# EUROPÄISCHE PATENTSCHRIFT

(11) **EP 1 057 385 B1**
(45) Veröffentlichungstag und Bekanntmachung des Hinweises auf die Patenterteilung: **28.08.2002**
(21) Anmeldenummer: 99911597.5
(22) Anmeldetag: 10.02.1999
(51) Int. Cl.: H05K 7/14

(54) **AUFBAUSYSTEM ZUM EINSCHUB VON ELEKTRISCHEN FLACHBAUGRUPPEN**
RACK SYSTEM FOR INSERTING ELECTRICAL PRINTED CIRCUIT BOARDS
SYSTEME DE RATELIER POUR L'INSERTION D'ENSEMBLES PLATS ELECTRIQUES

(30) Priorität: 23.02.1998 DE 19807555
(43) Veröffentlichungstag der Anmeldung: 06.12.2000
(73) Patentinhaber: RITTAL Electronic Systems GmbH & Co. KG, 90542 Eckental (DE)
(72) Erfinder: KURRER, Siegfried, D-90449 Nürnberg (DE); SCHAFFER, Kurt-Michael, D-90542 Eckental (DE); BILLENSTEIN, Ernst, D-91593 Burgbernheim (DE)
(74) Vertreter: Fleck, Hermann-Josef, Dr.-Ing.
(86) Internationale Anmeldenummer: DE9900395
(87) Internationale Veröffentlichungsnummer: WO99043189

(56) Entgegenhaltungen:
- EP-A- 0 579 859
- WO-A-93/03594
- WO-A-96/42187

## Beschreibung

Die Erfindung betrifft ein Aufbausystem mit einem Baugruppenträger mit Einbauplätzen für den Einschub von elektrischen Flachbaugruppen.

Der Baugruppenträger eines derartigen Aufbausystems stellt Volumenelemente bereit, welche zum Einschub von elektrischen Flachbaugruppen vorgesehen sind. Diese werden auch als sogenannte Einbauplätze bezeichnet und sind in der Regel parallel nebeneinander liegend angeordnet. In diese können elektrische Flachbaugruppen eingeschoben werden, welche dann ebenfalls parallel nebeneinander liegen.

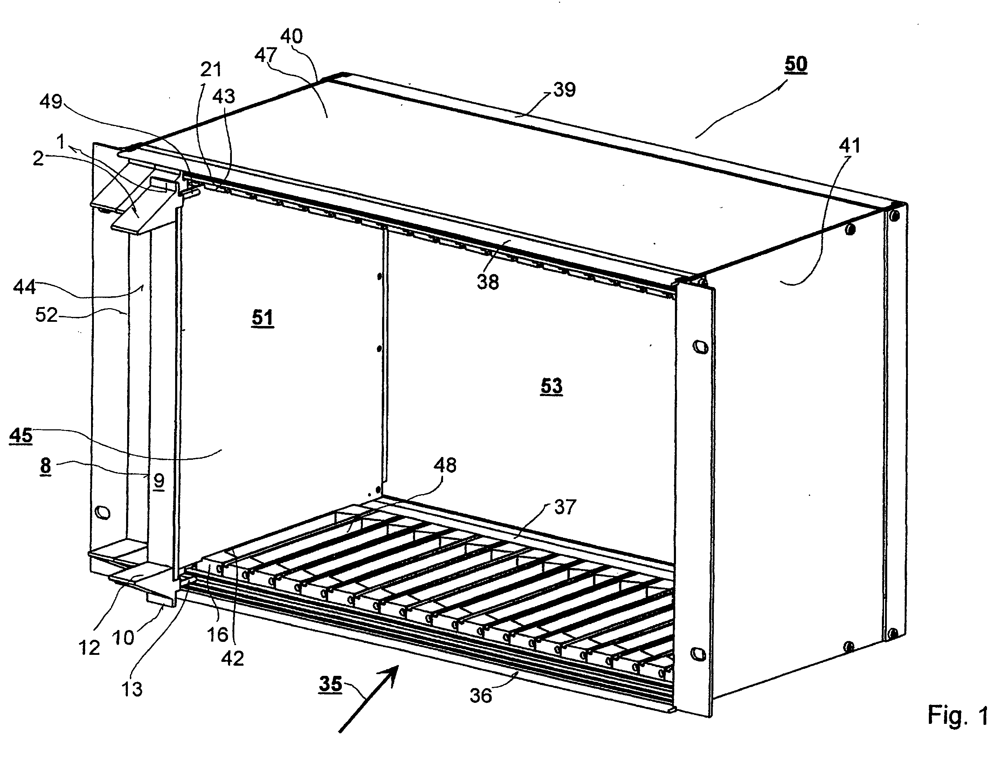

Ein standardmäßiger Grundaufbau eines Baugruppenträgers 50 ist in Figur 1 beispielhaft dargestellt. Der Aufnahmeraum für Flachbaugruppen wird begrenzt von gegenüberliegenden Querverbindungsschienen aus elektrisch leitendem Material. Im Beispiel der Figur 1 sind zwei untere Querverbindungsschienen 36,37 und zwei gegenüberliegende, obere Querverbindungsschienen 38,39 vorhanden. Dabei begrenzen die Querverbindungsschienen 36,38 die Vorderseite des Baugruppenträgers 50, d.h. die für die Einbringung von elektrischen Flachbaugruppen vorgesehene Einschubseite 35. Die beiden Querverbindungsschienen 37,39 begrenzen die Rückseite des Baugruppenträgers 50, welche z.B. durch eine sogenannte Rückwandleiterplatte abgeschlossen sein kann.

Die Querverbindungsschienen 36,37,38,39 können an den Seiten z.B. im Inneren eines Schaltschrankes montiert sein. Im Beispiel der Figur 1 sind vertikale Seitenwandbleche 41,47 vorhanden, mit denen die Querverbindungsschienen seitlich verschraubt sind. Schließlich ist die Ober- bzw. Unterseite des Baugruppenträgers 50 mit einem oberen bzw. unteren Abdeckblech 47,48 verschlossen. Zum Verschluß der Einschubseite 35 des Baugruppenträgers 50 sind sogenannte Frontelemente vorgesehen, welche den einzelnen Einbauplätzen im Inneren des Baugruppenträgers zugeordnet, an deren Breite angepaßt und aufsteck- bzw. abziehbar ausgestaltet sind. Diese Verschlußmöglichkeit ist dabei unabhängig davon, ob der hinter einem Frontelement liegende Einbauplatz mit einer elektrischen Flachbaugruppe belegt ist oder nicht. Es können somit einerseits freie Einbauplätze mit einem auf die Einschubseite 35 des Baugruppenträgers 50 aufgeschobenen Frontelement in der Art einer Leerplatzabdeckung verschlossen werden. Andererseits können elektrische Flachbaugruppen an einer Stirnseite mit einem Frontelement versehen sein, so daß nach deren Einschub in den Baugruppenträger 50 das Frontelement den entsprechenden Einbauplatz auf der Einschubseite 35 abdeckt.

Im Beispiel der Figur 1 sind für die an der linken Seite des Baugruppenträgers 50 befindlichen beiden Einbauplätze 44,45 Frontelemente 52, 8 vorhanden. Die Frontelemente sind dabei beispielhaft mehrteilig ausgeführt. So enthält das Frontelement 8 eine vertikale Frontplatte 9 aus elektrisch leitendem Material. Deren untere und obere Stirnseiten sind mit je einem Endstück 10,1 versehen, welches in der Regel ebenfalls aus einem elektrisch leitenden Material besteht. An diesen Endstücken sind beispielhaft sogenannte Hebelziehgriffe 12,2 drehbar gelagert. Diese können von einer Person insbesondere durch Schwenkbewegungen so bedient werden, daß ein Einschieben bzw. Herausziehen zumindest des Frontelementes 8 auf einfache Weise möglich ist.

Im Beispiel der Figur 1 ist das Frontelement 52 in einer abdeckenden Weise bereits vollständig auf den dahinter liegenden Einbauplatz 44 aufgeschoben und liegt in der Ebene der Einschubseite 35 des Baugruppenträgers 50. Das Frontelement 8 des daneben befindlichen Einbauplatzes 45 ist beispielhaft fest mit einer Flachbaugruppe 51 verbunden. Die Verbindung erfolgt dabei vorteilhaft mit Hilfe der beiden Endstücke 10,1. Die Flachbaugruppe ist bereits weitgehend in den Einbauplatz 45 eingeschoben. Nach einem vollständigen Einschub in den Einbauplatz 45 würde das Frontelement 8 bündig neben dem Frontelement 52 ebenfalls in der Ebene der Einschubseite 35 zu liegen kommen.

Beim Einschieben von Frontelementen bzw. Einheiten aus Frontelementen und elektrischen Flachbaugruppen müssen diese Elemente insbesondere unmittelbar vor Erreichen des vollständig eingeschobenen Zustandes in Einschubrichtung zentriert werden. Hierdurch wird ein versehentlicher seitlicher Versatz insbesondere der Frontelemente vermieden, welcher das vollständige Einschieben behindern bzw. unter Umständen sogar vereiteln würde. Diese Zentrierung ist insbesondere dann notwendig, wenn benachbarte Einbauplätze bereits auf der Einschubseite mit Frontelementen abgedeckt sind. Das einzuschiebende Frontelement muß dabei möglichst genau zentriert auf die freie Öffnung des jeweiligen Einbauplatzes zugeführt werden. Desweiteren ist nach dem vollständigen Aufschieben eine Sicherung von Frontelementen gegen Herausfallen insbesondere dann notwendig, wenn des Frontelement mit einer im Inneren des Einbauplatzes befindlichen elektrischen Flachbaugruppe fest verbunden ist. Schließlich sollten Frontelemente insbesondere dann, wenn diese und deren Teile weitgehend aus elektrisch leitenden Materialien bestehen, sicher elektrisch leitend mit dem Baugruppenträger kontaktiert sein, insbesondere mit dessen Querverbindungsschienen. Hierdurch wird eine Verbindung der Frontelemente mit der Schutzkontaktierung des Baugruppenträgers bewirkt, so daß z.B. auch hohe Fehlerströme von Frontelementen auf den Baugruppenträger abgeleitet und hierdurch Netzschutzeinrichtungen, wie z.B. Lasttrennschalter oder Fehlerstromschutzschalter mit einer den Personenschutz gewährleistenden Geschwindigkeit ausgelöst werden können.

Zur Zentrierung und Sicherung eines Frontelements sind bereits verschiedene Ausführungen bekannt.

So aus der EP 0 579 859 B1 eine Flachbaugruppe mit Führungsstiften zum positionsgenauen Einschub in einen Baugruppenträger bekannt. Dabei sind zur Zentrierung an den Außenseiten der Eckmontagekörper einer Flachbaugruppe zwei Führungsstifte vorhanden, welche sich beim Einschieben an den Seitenflanken des gegenüberliegenden Kopfendes einer Längsführungsschiene abstützen. Zusätzlich ist zwischen den Führungsstiften ein Massekontaktstift angeordnet, welcher beim Einschieben der Flachbaugruppe in eine, mit einer Massekontaktfeder belegten Kodierkammer an der Stirnseite des gegenüberliegenden Kopfendes der Längsführungsschiene eintaucht. Schließlich weist der Eckmontagekörper eine Montagebohrung zur Aufnahme einer Schraube auf. Diese kann zur Sicherung der Flachbaugruppe gegen Herausfallen mit Haltemitteln in Verbindung gebracht werden, welche in einem querverlaufenden Aufnahmeschlitz der Querverbindungsschiene gelagert sind. Diese Anordnung weist zum einen den Nachteil auf, daß vier unterschiedliche Elemente vorhanden sind, um die Funktionen Zentrierung, Massekontaktierung und Herausfallsicherung bereitzustellen. Ein weiterer Nachteil besteht darin, daß die zur Massekontaktierung vorgesehenen Mittel für eine Schutzkontaktierung nicht ausreichend sind. Ferner wird hierdurch die Funktion der Kodierelemente und Kodierkammern beeinträchtigt.

Aus der WO 96/42187 ist desweiteren ein Frontsystem für eine Flachbaugruppe mit Aktiv-Passiv-Schaltung bekannt. Zur Zentrierung weist das Endstück der dortigen Flachbaugruppe einen Führungsstift auf, welcher zum Eingriff in eine gegenüberliegende Führungsbohrung vorgesehen ist. Zur Sicherung gegen Herausfallen ist auch bei dieser Anordnung eine zusätzliche Schraube am Endstück vorgesehen, welche im eingeschobenen Zustand in eine Gewindeschiene einschraubbar ist, die in einer Quernut im Inneren der gegenüberliegenden Querverbindungsschiene gelagert ist. Auch diese Anordnung weist den Nachteil der Mehrteiligkeit auf. Ferner sind keine zusätzlichen Elemente zur elektrischen Schutzkontaktierung zwischen Frontelement und Querverbindungsschienen vorhanden.

Schließlich ist aus der WO 97/49270 ein Baugruppenträger mit zentrierbaren Frontplatten aufweisenden, einsteckbaren Baugruppen bekannt. An einem Ende einer derartigen Frontplatte ist dabei eine durch die Frontplatte hindurch reichende Schraube vorhanden. In der gegenüberliegenden Querverbindungsschiene sind ferner in Querrichtung verlaufende Führungsmittel gelagert, mit denen die Schraube beim Einschieben einer mit der Frontplatte versehenen Flachbaugruppe in den entsprechenden Baugruppenträger in Kontakt tritt. Die Führungsmittel weisen einen vorgelagerten Zentrierbereich und einen dahinter gelagerten Gewindebereich auf. Bei einer Ausführung ist der Zentrierbereich durch eine Zentrierleiste mit äquidistanten Zentrierlöchern, und der Gewindebereich durch eine dahinter befindliche Gewindeleiste mit äquidistanten Gewindelöchern ausgeführt. Diese Anordnung hat den Nachteil, daß eine paßgenaue Abstimmung der beteiligten Teile notwendig ist. Ferner sind keine zusätzlichen Elemente zur elektrischen Schutzkontaktierung zwischen Frontplatte und Querverbindungsschienen vorhanden.

Der Erfindung liegt die Aufgabe zu Grunde, eine Anordnung mit einem zum Einschub von elektrischen Flachbaugruppen vorgesehenen Baugruppenträger anzugeben, bei der die Funktionen Zentrierung des Frontelementes einer Flachbaugruppe beim Einschieben in einen Einbauplatz, Sicherung eines Frontelementes mit Flachbaugruppe gegen Lockerung bzw. Herausfallen aus dem Einbauplatz und Schutzkontaktierung des Frontelementes einer Flachbaugruppe im eingeschobenen Zustand, sowohl auf einfachere als auch auf sicherere Weise erreicht werden.

Die Aufgabe wird gelöst mit einem Aufbausystem gemäß dem Anspruch 1. Weitere, vorteilhafte Ausführungsformen der Erfindung sind in den Unteransprüchen enthalten.

Das Aufbausystem gemäß der Erfindung enthält einen Baugruppenträger mit Einbauplätzen für den Einschub von elektrischen Flachbaugruppen, welcher zur Begrenzung von Einbauplätzen zumindest gegenüberliegende Querverbindungsschienen aus elektrisch leitendem Material enthält. Für die Einbauplätze sind aufsteck- und abziehbare Frontelemente aus elektrisch leitendem Material vorhanden, welche zumindest mit einem in Richtung auf eine Einschubseite des Baugruppenträgers (50) vorstehenden, steck- und ziehbaren Zentrier- und Kontaktelement versehen sind. Es sind weiterhin vorhanden Aufnahmeelemente für die steck- und ziehbaren Zentrier- und Kontaktelemente aus elektrisch leitendem Material, die jeweils einem Einbauplatz zugeordnet und an einer Einschubseite des Baugruppenträgers an einer Querverbindungsschiene niederohmig angebracht sind. Die Aufnahmeelemente und die steck- und ziehbaren Zentrier- und Kontaktelemente treten bereits während eines Steckvorganges mechanisch zentrierend in Kontakt und bilden im gesteckten Zustand sowohl eine rüttelsichere mechanische Kontaktierung mit hoher Haftkraft, als auch eine elektrisch niederohmige Kontaktierung mit hoher Stromtragefähigkeit.

Das erfindungsgemäße Aufbausystem weist besondere Vorteile auf, welche insbesondere auf der konstruktiven Gestaltung der mit den Frontelementen verbundenen Zentrier- und Kontaktelemente, und sowohl der konstruktiven Gestaltung der gegenüberliegenden Aufnahmeelemente als auch deren niederohmige Kontaktierung mit einer Querverbindungsschiene beruhen. Diese Gestaltungen ermöglichen es, daß die drei Funktionen der mechanischen Zentrierung während des Steckvorganges, der mechanischen Halterung mit Sicherung gegen Herausfallen im vollständig auf- bzw. eingesteckten Zustand und der elektrisch niederohmigen Kontaktierung mit hoher Stromtragefähigkeit, welche den an eine Schutzkontaktierung gestellten Anforderungen entspricht, gleichzeitig erfüllt werden können. Insbesondere kann auf zusätzliche Schraubverbindungen verzichtet werden, welche bei den bislang bekannten Anordnungen zwischen Frontelement und Querverbindungsschiene im vollständig eingeschobenen Zustand eines Frontelementes und einer damit verbundenen elektrischen Flachbaugruppe aktiviert werden.

Gemäß einer vorteilhaften, weiteren Ausführung des erfindungsgemäßen Aufbausystems sind Verbindungsmittel zur dauerhaft elektrisch niederohmigen Verbindung eines Aufnahmeelementes an einer Querverbindungsschiene vorhanden. Diese können bevorzugt in Form einer Schraubverbindung ausgeführt sein und bilden eine Verbindung, welche dauerhaft niederohmig ist und eine hohe Stromtragefähigkeit aufweist. So kann auch diese Verbindung die an eine Schutzkontaktierung gestellten Anforderungen erfüllen.

Bei einem Aufbausystem gemäß der Erfindung können Führungsschienen zur Erleichterung des Einschubes von Flachbaugruppen in die Einbauplätze insbesondere paarweise gegenüberliegend auf den Querverbindungsschienen angebracht sein. Es ist dann vorteilhaft, wenn in einem Einbauplatz das mindestens eine Aufnahmeelement auf einer Querverbindungsschiene unmittelbar neben einer Führungsschiene liegend angeordnet ist, insbesondere neben deren Kopfende liegend. Vorteilhaft können die Aufnahmeelemente block- oder klötzchenförmig gestaltet sein. Bei einer derartigen Gesamtanordnung ist es dann besonders vorteilhaft, wenn pro Einbauplatz das mindestens eine Aufnahmeelement und die dazugehörige, mindestens eine Führungsschiene in Form eines einzigen Bauteils einteilig aus elektrisch leitendem Material ausgeführt sind.

Bei einer weiteren, besonders vorteilhaften Ausführung des erfindungsgemäßen Aufbausystems ist ein zusätzliches Kontaktmittel zwischen einem Aufnahmeelement und einem Zentrier- und Kontaktelement vorhanden. Hierdurch kann sowohl die mechanische Klemmung bzw. Haftung, als auch die elektrische Kontaktierung zwischen beiden Elementen weiter gesteigert werden.

Bei einer ersten Ausführung ist das zusätzliche Kontaktmittel mit einem Zentrier- und Kontaktelement verbunden. Die Verbindung erfolgt vorteilhaft durch Aufstecken des zusätzlichen Kontaktmittels auf das Zentrier- und Kontaktelement, insbesondere an dessen vorderem Kontaktbereich. Diese Art der Anbringung wird weiter erleichtert, wenn die Zentrier- und Kontaktelemente in Form von bevorzugt zylindrischen Stiften ausgeführt sind, und das zusätzliche Kontaktmittel die Form einer Korbfeder mit nach außen gerichteten Federkontaktlamellen aufweist. Weisen die Aufnahmeelemente schließlich an einer, der Einschubseite des Baugruppenträgers zugewandten Seite eine erste Eintrittsöffnung auf, so taucht in diese das mit einem zusätzlichen Kontaktmittel versehene Zentrier- und Kontaktelement eines Frontelements beim Aufschiebevorgang zentrierend ein. Durch die dann im Inneren der ersten Eintrittsöffnung befindlichen Kontaktmittel kann sowohl die mechanische Haftung als auch die elektrische Kontaktierung zwischen einem Zentrier- und Kontaktelement und einem Aufnahmeelement gesteigert werden.

Bei einer zweiten Ausführung ist das zusätzliche Kontaktmittel mit einem Aufnahmeelement verbunden. Die Verbindung kann vorteilhaft dadurch erfolgen, daß ein Aufnahmeelement an einer, der Einschubseite des Baugruppenträgers zugewandten Seite eine erste Eintrittsöffnung für ein Zentrier- und Kontaktelement aufweist, und das zusätzliche Kontaktmittel dahinter in einem Kontaktraum gelagert ist. Vorteilhaft kann ein derartiges Aufnahmeelement an einer, der Einschubseite des Baugruppenträgers abgewandten Seite eine zweite Eintrittsöffnung zur Einführung eines zusätzlichen Kontaktmittels in den Kontaktraum aufweisen. Bevorzugt weist ein zusätzliches Kontaktmittel an dieser abgewandten Seite Mittel zur Verrastung mit dem Aufnahmeelement auf, insbesondere abgespreizte Rastkrallen. Diese greifen bevorzugt in einen Schlitz im Aufnahmeelemente ein. Die Lagerung eines zusätzlichen Kontaktmittels in bzw. dessen Verrastung mit einem Aufnahmeelement wird weiter begünstigt, wenn dieses die Form einer Käfigfeder mit nach innen gerichteten Federkontaktlamellen aufweist.

Die Erfindung wird desweiteren anhand der in den nachfolgend kurz angeführten Figuren dargestellten Ausführungsbeispielen weiter erläutert. Dabei zeigt
- FIG 1: eine perspektivische Seitenansicht eines Aufbausystems gemäß der Erfindung,
- FIG 2: eine ausschnittsweise Detaildarstellung des unteren Bereiches eines Einbauplatzes mit einem Frontelement, und einer ersten beispielhaften Ausführungsform für ein Aufnahmeelement und einer ersten beispielhaften Ausführungsform für ein Zentrier- und Kontaktelement,
- FIG 3: eine der Figur 2 entsprechende ausschnittsweise Detaildarstellung eines Einbauplatzes, wobei gemäß einer weiteren Ausführung der Erfindung ein Aufnahmeelement und eine Führungsschiene einteilig ausgeführt sind,
- FIG 4: eine weitere ausschnittsweise Detaildarstellung des unteren Bereiches eines Einbauplatzes mit einem Frontelement, und einer zweiten beispielhaften Ausführungsform für ein Aufnahmeelement und einer zweiten beispielhaften Ausführungsform für ein Zentrier- und Kontaktelement,
- FIG 5: eine Schnittdarstellung durch die der Figur 2 entsprechende ausschnittsweise Detaildarstellung eines Einbauplatzes, und
- FIG 6: eine beispielhafte Ausführung für ein zusätzliches Kontaktmittel zwischen einem Aufnahmeelement und einem Zentrier- und Kontaktelement in Form einer Käfigfeder, welche mit einem Aufnahmeelement verbunden ist.

In der oben bereits teilweise erläuterten Figur 1 sind das Frontelement 8 und die dazugehörige Flachbaugruppe 51 des Einbauplatzes 45 bereits gemäß der Erfindung mit in Richtung auf die Einschubseite 35 des Baugruppenträgers 50 vorstehenden, steck- und ziehbaren Zentrier- und Kontaktelementen 13,49 versehen. Diese sind beispielhaft jeweils an einem unteren und oberen Eckstück 10,1 angebracht, wobei die Eckstücke 10,1 an den stirnseitigen Enden einer Frontplatte 9 fixiert sind. Die Eckstücke dienen ebenfalls zur Halterung eines unteren und oberen Hebelziehgriffes 12,2, womit eine Ein- bzw. Aushebelung der Einheit aus Frontelement 8 und Flachbaugruppe 51 erleichtert wird. Die Eckstücke mit den Zentrier- und Kontaktelementen und die Frontplatte sind ebenso wie die Querverbindungsschienen aus elektrisch leitendem Material gefertigt.

Die unteren und oberen Querverbindungsschienen 36,37 und 38,39 sind auf den Innenseiten, welche den zwischenliegenden Einbauplätzen zugewandt sind, mit Führungsschienen belegt. Dabei ist jedem Einbauplatz je ein Paar von gegenüber liegenden Führungsschienen zugeordnet, in denen die Kanten einer zwischenliegenden Flachbaugruppe geführt werden. Im Beispiel der Figur 1 sind dem Einbauplatz 45 die Führungsschienen 42,43 zugeordnet. Gemäß einer vorteilhaften Ausführung der Erfindung sind neben den Stirnseiten einer jeden Flachbaugruppe Aufnahmeelemente angeordnet, welche wiederum den Zentrier- und Kontaktelementen zugeordnet sind. In Figur 1 sind den Zentrier- und Kontaktelementen 13,49 am Frontelement 8 die Aufnahmeelemente 16,21 zugeordnet. Diese sind vorteilhaft einteilig mit den nebenliegenden Führungsschienen 42,43 ausgeführt. Dies wird nachfolgend noch näher erläutert werden.

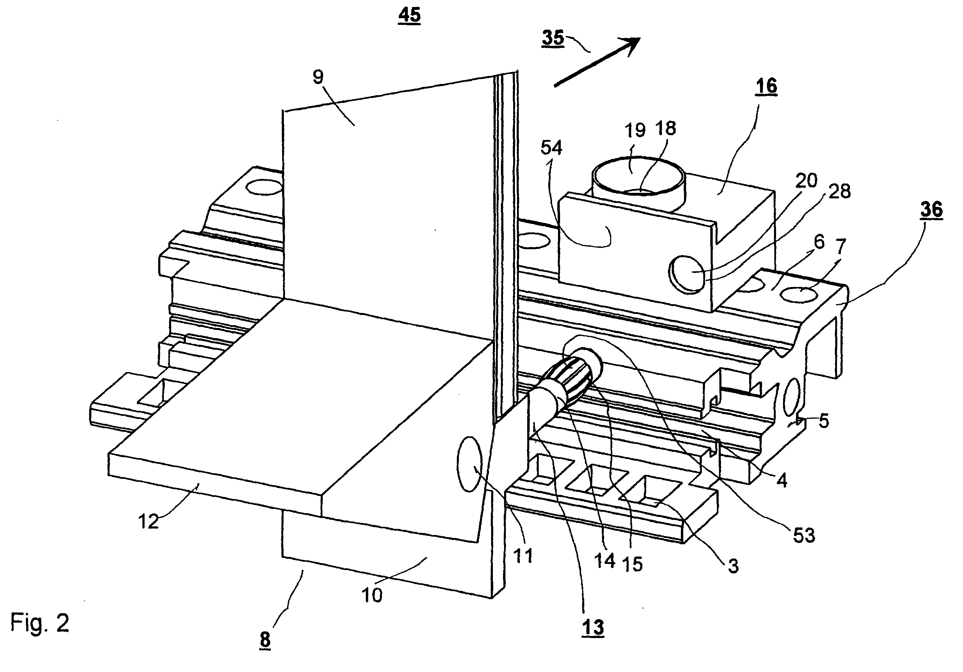

In Figur 2 ist eine ausschnittsweise Detaildarstellung des unteren Bereiches des Einbauplatzes 45 von Figur 2 mit dem Frontelement 8 dargestellt. Dieses enthält eine Frontplatte 9 mit dem Endstück 10 am unteren Ende, an dem über mindestens einen Drehpunkt 11 ein Hebelziehgriff 12 schwenkbar gelagert ist. Der Hebelziehgriff 12 ist in Figur 2 nur schematisch dargestellt. Am Endstück 10 ist ferner ein bevorzugt in Form eines zylindrischen Stiftes ausgeführtes Zentrier- und Kontaktelement 13 angebracht, welches in Richtung auf die Einschubseite 35 vorsteht. Diesem ist ein Aufnahmeelement 16 zugeordnet, welches eine vorteilhafte blockförmige Gestaltung aufweist, und auf einer, in das Innere des Baugruppenträgers gerichteten Auflagefläche 6 der unteren Querverbindungsschiene 36 angebracht ist. Die Querverbindungsschiene weist dabei einen üblichen Aufbau auf und enthält z.B. unterhalb des Einschubbereiches eine quer verlaufende Schiene mit Eingriffsöffnungen für nicht näher dargestellte Abstützelemente des Hebelziehgriffes 12. Dahinter liegt eine Quernut 4, in die z.B. eine Gewindelochschiene einschiebbar ist, in die Fixierschrauben eindrehbar wären. Diese Quernut 4 ist im Beispiel der Figur 2 nicht belegt, da bei der erfindungsgemäßen Ausführung des Frontelementes 8 keine Fixierschrauben benötigt werden. Über die seitliche Stirnseite 5 ist die untere Querverbindungsschiene 36 z.B. mit einem Seitenwandblech 41 verschraubbar. Schließlich ist die innere Auflagefläche 6 mit einer Reihe von Montagelöchern 7 versehen.

In Figur 1 sind die Frontplatte 9, das Endstück 10, das Zentrier- und Kontaktelement 13, die Querverbindungsschiene 36 und das Aufnahmeelement 16 aus elektrisch leitendem Material gefertigt. Zur Herstellung einer dauerhaften, besonders niederohmigen und stromtragefähigen Verbindung ist das Aufnahmeelement 16 über ein Verbindungselement 18 fest mit der Querverbindungsschiene 36 verbunden. Vorteilhaft wird hierzu eine Schraubverbindung eingesetzt, welche z.B. über trichterförmige Zentriermittel 19 durch den Block des Aufnahmeelementes 16 hindurch bis in eines der Montagelöcher 7 reicht.

Bei der in Figur 1 dargestellten Ausführung der Erfindung weist das Aufnahmeelement 16 an einer, der Einschubseite 35 des Baugruppenträgers 50 zugewandten Seite 54 eine erste Eintrittsöffnung 20 mit einem dahinter befindlichen Kontakthohlraum auf. In diese taucht das Zentrier- und Kontaktelement 13 während einer in Einschubrichtung 35 orientierten Bewegung des Frontelementes 8 ein, so daß dabei eine Zentrierung bewirkt wird. Nach einem vollständigen Aufschieben des Frontelementes 8 ist das Zentrier- und Kontaktelement 13 insbesondere über dessen vorderen Kontaktbereich 14 derart in den Aufnahmeraum 28 des Aufnahmeelementes 16 eingetaucht, daß sowohl eine rüttelsichere, mechanische Verbindung mit hoher Haftkraft, als auch eine dauerhafte, elektrisch niederohmige Verbindung mit hoher Stromtragefähigkeit zwischen beiden Elementen entstanden ist. Der in Einschubrichtung 35 hinter Querverbindungsschiene 36 und Aufnahmeelement 16 liegende Einbauplatz 45 ist somit vollständig nach vorne abgedeckt. Bei dem in Figur 1 dargestellten Beispiel ist der Einbauplatz 45 nicht mit einer Flachbaugruppe belegt, so daß das Frontelement in diesem Fall die Funktion einer sogenannten Blindabdeckung übernimmt.

Bei dem in Figur 1 dargestellten Beispiel ist bereits entsprechend einer weiteren, besonders vorteilhaften Ausführung der Erfindung ein zusätzliches Kontaktmittel 15 zwischen dem Zentrier- und Kontaktelement 13 und dem Aufnahmeelement 16 vorhanden. Dieses ist beispielhaft dem Zentrier- und Kontaktelement 13 zugeordnet und in Form einer annähernd zylindrischen Korbfeder 15 mit nach außen gerichteten Federkontaktlamellen 53 auf den vorderen Kontaktbereich 14 aufgeschoben. Nach dem Eintauchen eines mit einer derartigen Korbfeder bestückten Zentrier- und Kontaktelementes 13 in den Aufnahmeraum 28 des Aufnahmeelementes 16 wird eine mechanische und elektrisch leitende Verbindung mit besonders hoher Druckkraft und besonders hoher Stromtragefähigkeit zwischen beiden Elementen aufgebaut.

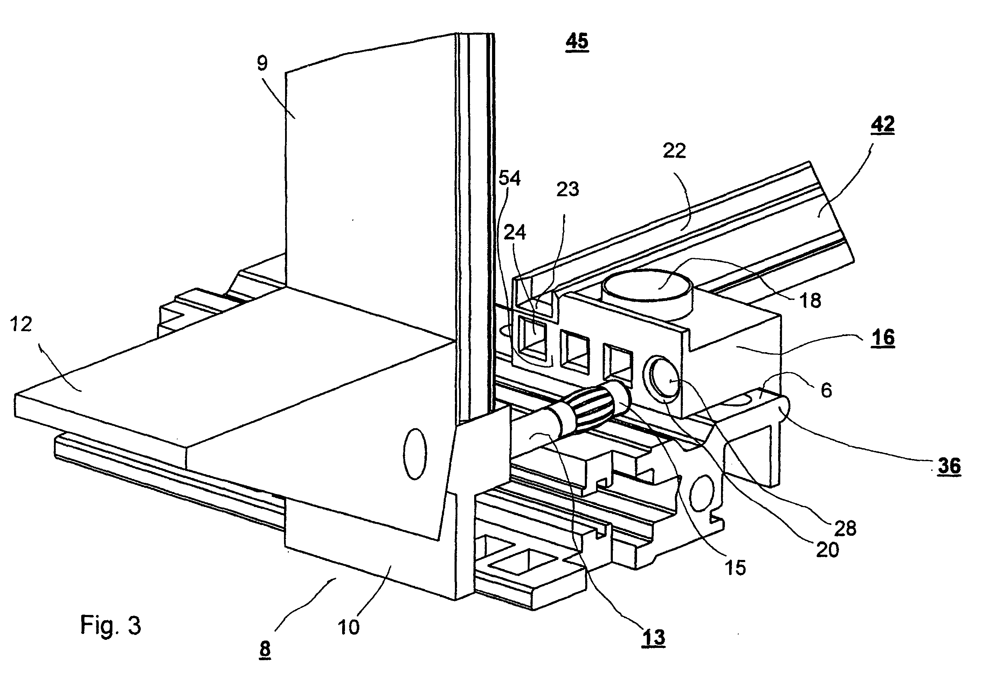

In Figur 3 ist eine der Figur 2 entsprechende ausschnittsweise Detaildarstellung des Einbauplatzes 45 mit dem Frontelement 8 gezeigt. Der Einbauplatz ist zusätzlich mit Führungsschienen für Flachbaugruppen bestückt, von denen in Figur 3 eine untere Führungsschiene 42 dargestellt ist. Diese ist neben dem Aufnahmeelement 16 plaziert und ebenfalls auf der innen liegenden Auflagefläche 6 der unteren Querverbindungsschiene 36 angebracht. Auf deren Oberseite befindet sich eine u-förmige Führungsnut 22. In diese kann über einen Einlaufbereich mit Einlaufschrägen 23 eine Flachbaugruppe über deren Seitenkanten in den Einbauplatz 45 eingeschoben und positioniert werden. Eine derartige Flachbaugruppe ist in der Regel zumindest über das Endstück 10 fest mit dem Frontelement 8 verbunden. In Figur 3 ist aus Gründen der besseren Übersicht eine Flachbaugruppe nicht dargestellt.

Gemäß einer besonders vorteilhaften Ausführung der Erfindung sind im Beispiel der Figur 3 die Führungsschiene 42 und das blockförmige Aufnahmeelement 16 einteilig aus einem elektrisch leitenden Material ausgeführt. Es ist somit mit Hilfe eines einzigen Verbindungselementes 18 möglich, die Einheit aus Führungsschiene und Aufnahmeelement dauerhaft elektrisch niederohmig mit der Querverbindungsschiene 36 zu verbinden. Die einteilige Ausführung weist den weiteren Vorteil auf, daß auf der, der Einschubseite 35 des Baugruppenträgers 50 zugewandten Seite 54 eine günstige Flächenaufteilung möglich ist. So können im Beispiel der Figur 3 neben der Aufnahmeöffnung 20 für das Zentrier- und Kontaktelement 13 weiterhin drei Kodierkammern 24 für sogenannte Kodierstifte angebracht werden.

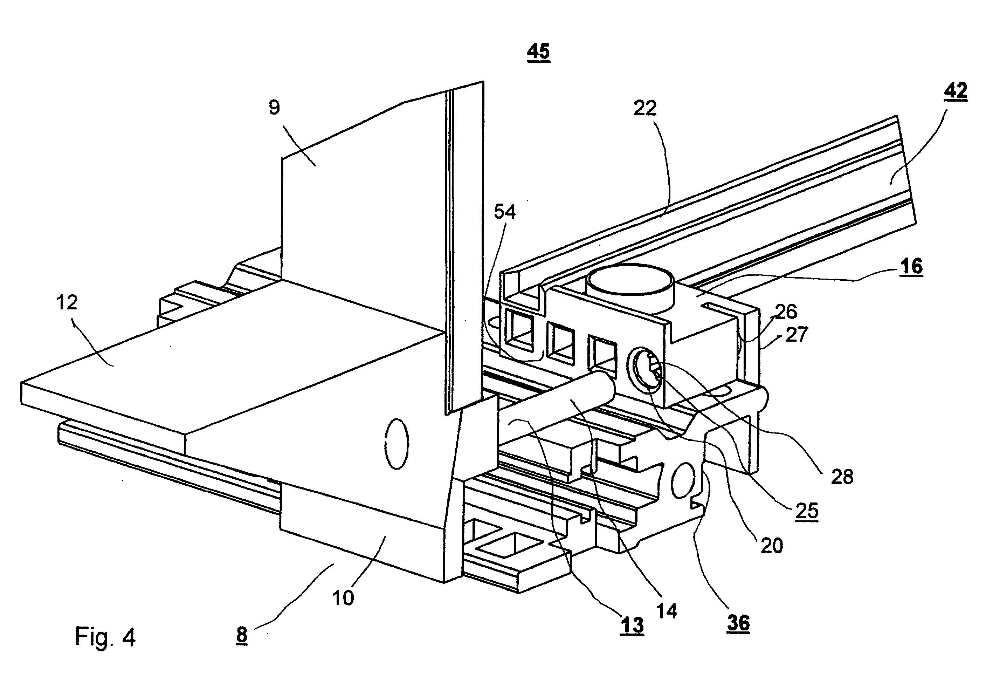

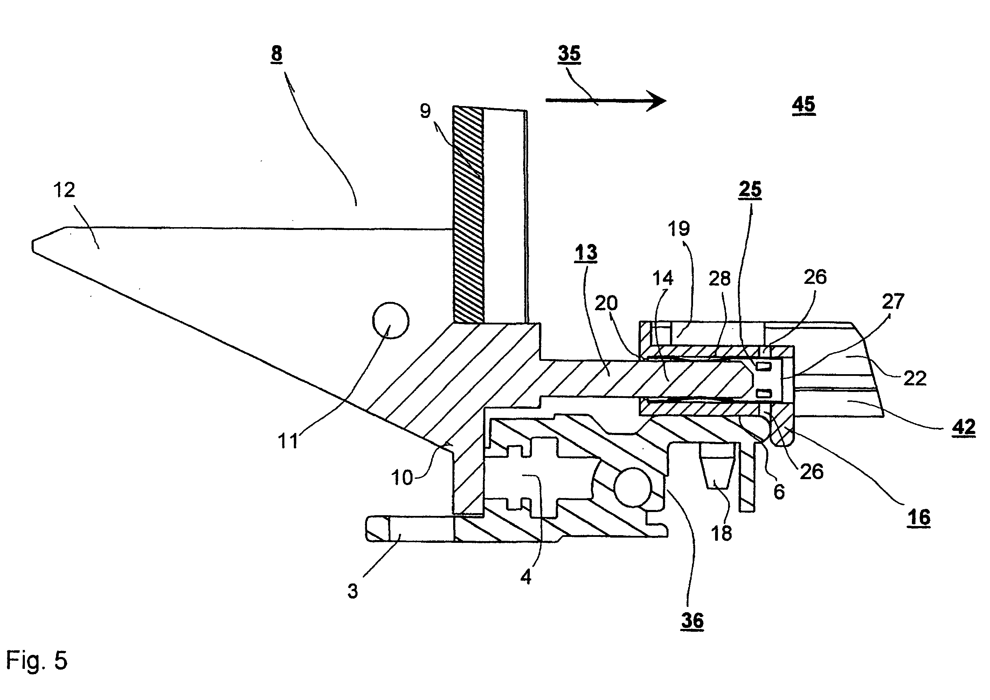

Figur 4 zeigt eine weitere, ausschnittsweise Detaildarstellung des unteren Bereiches des Einbauplatzes 45 mit dem Frontelement 8. Diese entspricht weitgehend der Anordnung von Figur 3 und weist ebenfalls eine einteilige Ausführung von Aufnahmeelement 16 und Führungsschiene 42 auf. Bei der Ausführung von Figur 4 ist das zusätzliche Kontaktelement allerdings dem Aufnahmeelement 16 zugeordnet, und beispielhaft in Form einer Käfig- bzw. Tonnenfeder 25 im Inneren des Kontakthohlraumes 28 hinter der Aufnahmeöffnung 20 gelagert. In diese taucht der vordere Kontaktbereich 14 des Zentrier- und Kontaktelementes 13 ein. Vorteilhaft weist der Block des Aufnahmeelementes 16 auf der, der Einschubseite 35 des Baugruppenträgers bzw. der Frontseite 54 abgewandten Seite eine zweite Eintrittsöffnung 27 auf. Diese ist der ersten Eintrittsöffnung 20 bevorzugt unmittelbar gegenüberliegend angeordnet und mündet ebenfalls in den Kontakthohlraum 28. Über diese zweite Eintrittsöffnung 27 kann das insbesondere käfigfederartige zusätzliche Kontaktelement 25 auf einfache Weise in den Kontakthohlraum eingeführt und darin plaziert werden. Die erste Eintrittsöffnung 20 kann dann einen geringeren Durchmesser aufweisen als der Kontakthohlraum 28. Der Durchmesser der ersten Eintrittsöffnung 20 ist somit optimal an den Außendurchmesser des Zentrier- und Kontaktelementes 13 anpaßbar. Ferner bildet eine somit verengte erste Eintrittsöffnung 20 eine sichere, innere Anlagekante für eine von hinten in den erweiterten Aufnahmeraum 28 eingeschobene Käfigfeder 25. Bevorzugt weist der Körper des Aufnahmeelementes 16 zusätzlich einen Schlitz 26 auf. In diesen können am hinteren Ende des zusätzlichen Kontaktelementes 25 befindliche Rastelemente eingreifen, so daß bei einem Eintauchen des Zentrierund Kontaktelementes 13 in den Kontakthohlraum 28 kein versehentliches Ausschieben des zusätzlichen Kontaktelementes 25 über die zweite Eintrittsöffnung 27 auftreten kann. Dies wird an Hand der nachfolgenden Figur 5 noch näher erläutert.

Figur 5 zeigt eine Schnittdarstellung durch die der Figur 4 entsprechende ausschnittsweise Detaildarstellung. Dabei ist das Frontelement 8 vollständig auf den Einbauplatz 45 und die Querverbindungsschiene 36 aufgeschoben. Das Zentrier- und Kontaktelement 13 befindet sich in dem vollständig in den Aufnahmeraum 28 des Aufnahmeelementes 16 eingeschobenen Zustand, und dessen Kontaktbereich 14 ist bei hoher Haftkraft und niederohmig mit dem eingelegten zusätzlichen Kontaktelement 25 kontaktiert. Dieses ist beispielhaft in Form einer Käfigfeder ausgeführt, welche über die zweite Aufnahmeöffnung 27 von hinten in den Kontakthohlraum 28 eingebracht ist. Zusätzlich Verrastelemente der Käfigfeder 25 greifen in den Rastschlitz 26 des Aufnahmeelementes 16 ein und bewirken eine sichere Lagerung.

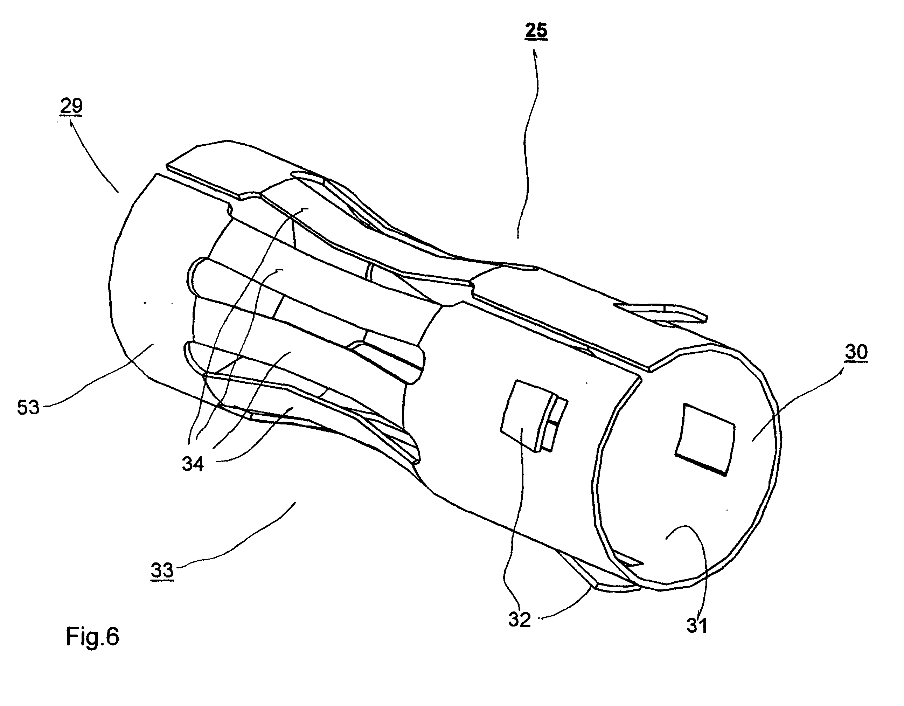

In Figur 6 ist schließlich eine beispielhafte Ausführung für ein zusätzliches Kontaktmittel zwischen einem Aufnahmeelement und einem Zentrier- und Kontaktelement in Form einer Käfigfeder dargestellt. Diese wird entsprechend den in den vorangegangenen Figuren 4 und 5 gezeigten Beispielen mit dem Aufnahmeelement 16 verbunden, insbesondere durch Lagerung im Inneren des Kontakthohlraumes 28. Die Käfigfeder 25 weist eine annähernd hohlzylindrische Form auf. Ein erster geschlitzter Haltering 53 bildet den vorderen Einführbereich 29 für das Zentrier- und Kontaktelement 13. Am gegenüberliegenden Ende ist ein zweiter geschlitzter Haltering 30 vorhanden, welcher einen Verrastbereich enthält. Der Haltering 30 trägt Mittel 32 zur Verrastung der Käfigfeder 25 mit dem Aufnahmeelement 16, welche bevorzugt in Form abgespreizten Verrastkrallen 32 ausgeführt sind. Zwischen dem ersten geschlitzten Haltering 53 und dem zweiten Haltering 30 sind eine Vielzahl von nach innen gebogenen Kontaktfederlamellen 34 angeordnet. In diesen verengten Kontakthohlraum wird das Zentrier- und Kontaktelementes 13 eingeführt. Insbesondere die Stärke des Materials der Käfigfeder und die Breite der Kontaktfederlamellen sind so ausgeführt, daß auf die Oberfläche des eingeführten Zentrier- und Kontaktelementes 13 eine hohe Druckkraft ausgeübt werden kann. Hierdurch wird sowohl eine rüttelsichere mechanische Kontaktierung mit hoher Haftkraft, als auch eine elektrisch niederohmige Kontaktierung mit hoher Stromtragefähigkeit hergestellt.

## Patentansprüche

1. Aufbausystem mit einem Baugruppenträger (50) mit Einbauplätzen (44,45) für den Einschub von elektrischen Flachbaugruppen (51), zumindest mit
a) gegenüberliegenden Querverbindungsschienen (36,37; 38,39) aus elektrisch leitendem Material zur Begrenzung von Einbauplätzen (44,45),
b) aufsteck- und abziehbaren Frontelementen (52,8) für Einbauplätze (44,45) aus elektrisch leitendem Material, welche zumindest mit einem in Richtung auf eine Einschubseite (35) des Baugruppenträgers (50) vorstehenden, steck- und ziehbaren Zentrier- und Kontaktelement (13,49) versehen sind, und mit
c) Aufnahmeelementen (16,21) für die steck- und ziehbaren Zentrier- und Kontaktelemente (13,49) aus elektrisch leitendem Material, die jeweils einem Einbauplatz (44,45) zugeordnet und an einer Einschubseite (35) des Baugruppenträgers (50) an einer Querverbindungsschiene (36,37;38,39) niederohmig angebracht sind, wobei
d) die Aufnahmeelemente (16,21) und die steck- und ziehbaren Zentrier- und Kontaktelemente (13,49)
i) bereits während eines Steckvorganges mechanisch zentrierend in Kontakt treten, und
ii) im gesteckten Zustand sowohl eine rüttelsichere mechanische Kontaktierung mit hoher Haftkraft, als auch eine elektrisch niederohmige Kontaktierung mit hoher Stromtragefähigkeit bilden.

2. Aufbausystem nach Anspruch 1, wobei aufsteck- und abziehbare Frontelemente (8)
a) eine Frontplatte (9) mit zumindest einem Endstück (10,1) aufweisen, und wobei
b) ein steck- und ziehbares Zentrier- und Kontaktelement (13,49) mit einem Endstück (10,1) in Verbindung steht.

3. Aufbausystem nach Anspruch 2, wobei das zumindest eine Endstück (10,1) eines aufsteck- und abziehbaren Frontelements (8) zur Halterung einer elektrischen Flachbaugruppe (51) dient.

4. Aufbausystem nach einem der vorangegangenen Ansprüche, mit einem Verbindungsmittel (18), insbesondere einer Schraubverbindung, zur dauerhaft elektrisch niederohmigen Verbindung eines Aufnahmeelementes (16) an einer Querverbindungsschiene (36), insbesondere auf einer den Einbauplätzen (44,45) zugewandten innenliegenden Auflagefläche (6).

5. Aufbausystem nach einem der vorangegangenen Ansprüche, mit Führungsschienen (42,43) zum Einschub einer Flachbaugruppe (51) in einen Einbauplatz (45), welche paarweise gegenüberliegend auf den Querverbindungsschienen (36,37;38,39) angebracht sind.

6. Aufbausystem nach Anspruch 5, wobei in einem Einbauplatz (45) das mindestens eine Aufnahmeelement (16) unmittelbar neben einer Führungsschiene (42) auf einer Querverbindungsschiene (36) angeordnet ist.

7. Aufbausystem nach Anspruch 6, wobei in einem Einbauplatz (45) ein Aufnahmeelement (16) und eine Führungsschiene (42) einteilig aus elektrisch leitendem Material ausgeführt sind.

8. Aufbausystem nach einem der vorangegangenen Ansprüche, mit blockförmigen Aufnahmeelementen (16).

9. Aufbausystem nach einem der vorangegangenen Ansprüche, wobei Zentrier- und Kontaktelemente (13,49) in Form von bevorzugt zylindrischen Stiften ausgeführt sind.

10. Aufbausystem nach einem der vorangegangenen Ansprüche, mit einem zusätzlichen Kontaktmittel (15,25) zwischen einem Aufnahmeelement (16) und einem Zentrier- und Kontaktelement (13).

11. Aufbausystem nach Anspruch 10, wobei ein zusätzliches Kontaktmittel (15) mit einem Zentrier- und Kontaktelement (13) verbunden ist. (Fig.2,3)

12. Aufbausystem nach Anspruch 11, wobei ein zusätzliches Kontaktmittel (15) auf einem Zentrier- und Kontaktelement (13) aufgesteckt ist, insbesondere am einem vorderen Kontaktbereich (14). (Fig.2,3)

13. Aufbausystem nach Anspruch 11 oder 12, wobei ein zusätzliches Kontaktmittel (15) die Form einer Korbfeder mit nach außen gerichteten Federkontaktlamellen (53) aufweist. (Fig.2,3)

14. Aufbausystem nach einem der Ansprüche 11 bis 13, wobei die Aufnahmeelemente (16) an einer, der Einschubseite (35) des Baugruppenträgers (50) zugewandten Seite (54), eine erste Eintrittsöffnung (20) für ein Zentrier- und Kontaktelement (13) mit einem zusätzlichen Kontaktmittel (15) aufweisen. (Fig.2,3)

15. Aufbausystem nach Anspruch 10, wobei ein zusätzliches Kontaktmittel (25) mit einem Aufnahmeelement (16) verbunden ist. (Fig.4,5)

16. Aufbausystem nach Anspruch 15, wobei die Aufnahmeelemente (16) an einer, der Einschubseite (35) des Baugruppenträgers (50) zugewandten Seite (54) eine erste Eintrittsöffnung (20) für ein Zentrier- und Kontaktelement (13) aufweisen, und das zusätzliche Kontaktmittel (25) dahinter in einem Kontaktraum (28) gelagert ist. (Fig.4,5)

17. Aufbausystem nach Anspruch 16, wobei die Aufnahmeelemente (16) an einer, der Einschubseite (35) des Baugruppenträgers (50) abgewandten Seite eine zweite Eintrittsöffnung (27) zur Einführung eines zusätzlichen Kontaktmittels (25) in den Kontaktraum (28) aufweisen. (Fig.4,5)

18. Aufbausystem nach Anspruch 16 oder 17, wobei ein zusätzliches Kontaktmittel (25) an einer, der Einschubseite (35) des Baugruppenträgers (50) abgewandten Seite (31) Mittel (32) zur Verrastung mit dem Aufnahmeelement aufweist, insbesondere abgespreizte Rastkrallen. (Fig.4,5)

19. Aufbausystem nach Anspruch 18, wobei die Aufnahmeelemente (16) einen Schlitz (26) zum Eingriff der Mittel (32) zur Verrastung mit dem Aufnahmeelement (16) aufweist.

20. Aufbausystem nach einem der Ansprüche 15 bis 19, wobei ein zusätzliches Kontaktmittel (25) die Form einer Käfigfeder mit nach innen gerichteten Federkontaktlamellen aufweist. (Fig.6)

## Claims

1. Rack system having a mounting rack (50) with slots (44, 45) for insertion of electrical printed circuit board assemblies (51), at least having
a) mutually opposite transverse connecting rails (36,37; 38,39) composed of electrically conductive material in order to bound the slots (44,45),
b) plug-on and pull-off front elements (52,8) for slots (44,45) composed of electrically conductive material, which are provided with at least one plug-in and withdrawable centring and contact element (13,49) projecting in the direction of the insertion side (35) of the mounting rack (50), and having
c) retaining elements (16,21) for the plug-in and withdrawable centring and contact elements (13,49), composed of electrically conductive material, which are each associated with one slot (44,45) and are fitted with low impedance to a transverse connecting rail (35,37;38,39) on an insertion side (35) of the mounting rack (50), wherein
d) the retaining elements (16,21) and the plug-in and withdrawable centring and contact elements (13,49)
i) come into contact, providing mechanical centring, during an insertion process, and
ii) when inserted, not only make a vibration-proof mechanical contact with a high adhesion force, but also make an electrically low-impedance contact with a high current carrying capacity.

2. Rack system according to Claim 1, wherein plug-on and pull-off front elements (8)
a) have a front panel (9) having at least one end piece (10,1), and wherein
b) a plug-in and withdrawable centring and contact element (13,49) is connected to an end piece (10,1).

3. Rack system according to Claim 2, wherein the at least one end piece (10,1) of a plug-on and pull-off front element (8) is used for holding an electrical printed circuit board assembly (51).

4. Rack system according to one of the preceding claims, having a connecting means (18), in particular a screw connection, for permanently electrically low-impedance connection of a retaining element (16) on a transverse connecting rail (36), in particular on an internal contact surface (6) facing the slots (44,45).

5. Rack system according to one of the preceding claims, having guide rails (42,43) for insertion of a printed circuit board assembly (51) into a slot (45), which guide rails (42,43) are fitted, in pairs and opposite one another, to the transverse connecting rails (36,37;38,39).

6. Rack system according to Claim 5, wherein the at least one retaining element (16) is arranged in a slot (45), immediately adjacent to a guide rail (42) on a transverse connecting rail (36).

7. Rack system according to Claim 6, wherein a retaining element (16) and a guide rail (42) in a slot (45)are formed integrally from electrically conductive material.

8. Rack system according to one of the preceding claims, having retaining elements (16) in the form of blocks.

9. Rack system according to one of the preceding claims, wherein centring and contact elements (13,49) are in the form of preferably cylindrical pins.

10. Rack system according to one of the preceding claims, having an additional contact means (15,25) between a retaining element (16) and a centring and contact element (13).

11. Rack system according to Claim 10, wherein an additional contact means (15) is connected to a centring and contact element (13). (Figures 2,3)

12. Rack system according to Claim 11, wherein an additional contact means (15) is plugged onto a centring and contact element (13), in particular on a front contact region (14). (Figures 2,3)

13. Rack system according to Claim 11 or 12, wherein an additional contact means (15) is in the form of a barrel spring having spring contact laminates (53) pointed outward. (Figures 2,3)

14. Rack system according to one of Claims 11 to 13, wherein, on a side (54) facing the insertion side (35) of the mounting rack (50), the retaining elements (16) have a first entry opening (20) for a centring and contact element (13) having an additional contact means (15). (Figures 2,3)

15. Rack system according to Claim 10, wherein an additional contact means (25) is connected to a retaining element (16). (Figures 4,5)

16. Rack system according to Claim 15, wherein, on a side (54) facing the insertion side (35) of the mounting rack (50), the retaining elements (16) have a first entry opening (20) for a centring and contact element (13), and the additional contact means (25) is mounted behind this, in a contact area (28). (Figures 4,5)

17. Rack system according to Claim 16, wherein, on a side facing away from the insertion side (35) of the mounting rack (50), the retaining elements (16) have a second entry opening (27) for insertion of an additional contact means (25) into the contact area (28). (Figures 4,5)

18. Rack system according to Claim 16 or 17, wherein, on a side (31) facing away from the insertion side (35) of the mounting rack (50), an additional contact means (25) has means (32) for latching to the retaining element, in particular spread latching claws. (Figure 6)

19. Rack system according to Claim 18, wherein the retaining element (16) has a slot (26) for engagement of the means (32) for latching to the retaining element (16).

20. Rack system according to one of Claims 15 to 19, wherein an additional contact means (25) is in the form of a spring cage with spring contact laminates pointing inward. (Figure 6)

## Revendications

1. Système de râtelier avec un support d'ensembles (50) comprenant des places de montage (44, 45) pour l'insertion d'ensembles plats électriques (51), avec au moins
a) des rails de liaison transversaux opposés (36, 37; 38, 39) en matériau électriquement conducteur servant à limiter les places de montage (44, 45),
b) des éléments frontaux (52, 8) pouvant être enfichés et retirés, pour des places de montage (44, 45) en matériau électriquement conducteur, qui sont pourvus d'au moins un élément de centrage et de contact (13, 49) pouvant être enfiché et retiré, saillant dans la direction d'un côté d'insertion (35) du support d'ensembles (50), et avec
c) des éléments de logement (16, 21) pour les éléments de centrage et de contact (13, 49) pouvant être enfichés et retirés en matériau électriquement conducteur, qui sont chacun associés à une place de montage (44, 45) et sont montés avec une faible impédance sur un côté d'insertion (35) du support d'ensembles (50) sur un rail de liaison transversal (36,
d) les éléments de logement (16, 21) et les éléments de centrage et de contact (13, 49) pouvant être enfichés et retirés
i) venant déjà en contact en se centrant mécaniquement au cours d'une opération d'enfichage, et
ii) formant dans l'état enfiché à la fois un contact mécanique résistant aux secousses avec une grande force d'adhésion, et un contact de faible impédance électrique avec une haute capacité de passage du courant.

2. Système de râtelier selon la revendication 1, dans lequel les éléments frontaux (8) pouvant être . enfichés et retirés :
a) présentent une plaque frontale (9) avec au moins un embout (10, 1), et dans lequel
b) un élément de centrage et de contact (13, 49) pouvant être enfiché et retiré est connecté à un embout (10, 1).

3. Système de râtelier selon la revendication 2, dans lequel l'au moins un embout (10, 1) d'un élément frontal (8) pouvant être enfiché et retiré sert à fixer un ensemble plat électrique (51).

4. Système de râtelier selon l'une quelconque des revendications précédentes, comprenant un moyen de connexion (18), en particulier un raccord à vis, pour la connexion de faible impédance électrique durable d'un élément de logement (16) à un rail de connexion transversal (36), en particulier sur une surface d'appui (6) intérieure tournée vers les places de montage (44, 45).

5. Système de râtelier selon l'une quelconque des revendications précédentes, comprenant des rails de guidage (42, 43) pour l'insertion d'un ensemble plat (51) dans une place de montage (45), lesquels rails sont montés par paire en face les uns des autres sur les rails de liaison transversaux (36, 37; 38, 39).

6. Système de râtelier selon la revendication 5, dans lequel l'au moins un élément de logement (16) est disposé dans une place de montage (45) directement à côté d'un rail de guidage (42) sur un rail de connexion transversal (36).

7. Système de râtelier selon la revendication 6, dans lequel un élément de logement (16) et un rail de guidage (42) sont réalisés d'une seule pièce en matériau électriquement conducteur, dans une place de montage (45).

8. Système de râtelier selon l'une quelconque des revendications précédentes, comprenant des éléments de logement en forme de blocs (16).

9. Système de râtelier selon l'une quelconque des revendications précédentes, dans lequel les éléments de centrage et de contact (13, 49) sont réalisés sous la forme de broches de préférence cylindriques.

10. Système de râtelier selon l'une quelconque des revendications précédentes, comprenant un moyen de contact supplémentaire (15, 25) entre un élément de logement (16) et un élément de centrage et de contact (13).

11. Système de râtelier selon la revendication 10, dans lequel un moyen de contact supplémentaire (15) est connecté à un élément de centrage et de contact (13). (Figures 2, 3).

12. Système de râtelier selon la revendication 11, dans lequel un moyen de contact supplémentaire (15) est enfiché sur un élément de centrage et de contact (13), en particulier sur une zone de contact avant (14). (Figures 2, 3).

13. Système de râtelier selon la revendication 11 ou 12, dans lequel un moyen de contact supplémentaire (15) présente la forme d'un ressort bombé avec des lamelles de contact à ressort (53) orientées vers l'extérieur. (Figures 2, 3).

14. Système de râtelier selon l'une quelconque des revendications 11 à 13, dans lequel les éléments de logement (16) présentent, sur un côté (54) tourné vers le côté d'insertion (35) du support d'ensembles (50), une première ouverture d'entrée (20) pour un élément de centrage et de contact (13) avec un moyen de contact supplémentaire (15). (Figures 2, 3).

15. Système de râtelier selon la revendication 10, dans lequel un moyen de contact supplémentaire (25) est connecté à un élément de logement (16). (Figures 4, 5).

16. Système de râtelier selon la revendication 15, dans lequel les éléments de logement (16) présentent, sur un côté (54) tourné vers le côté d'insertion (35) du support d'ensembles (50), une première ouverture d'entrée (20) pour un élément de centrage et de contact (13), et le moyen de contact supplémentaire (25) est monté derrière, dans un espace de contact (28). (Figures 4, 5).

17. Système de râtelier selon la revendication 16, dans lequel les éléments de logement (16) présentent, sur un côté opposé au côté d'insertion (35) du support d'ensembles (50), une deuxième ouverture d'entrée (27) pour l'introduction d'un moyen de contact supplémentaire (25) dans l'espace de contact (28). (Figures 4, 5).

18. Système de râtelier selon la revendication 16 ou 17, dans lequel un moyen de contact supplémentaire (25) présente, sur un côté (31) opposé au côté d'insertion (35) du support d'ensembles (50), des moyens (32) pour l'enclenchement avec l'élément de logement, en particulier des griffes d'accrochage écartées. (Figures 4, 5).

19. Système de râtelier selon la revendication 18, dans lequel les éléments de logement (16) présentent une fente (26) pour engager les moyens (32) pour l'enclenchement avec l'élément de logement (16).

20. Système de râtelier selon l'une quelconque des revendications 15 à 19, dans lequel un moyen de contact supplémentaire (25) présente la forme d'un ressort de cage avec des lamelles de contact à ressort orientées vers l'intérieur. (Figure 6).
